**Europäisches Patentamt**

**European Patent Office**

**Office européen des brevets**

(11) Veröffentlichungsnummer: **0 450 316 A2**

## (12) EUROPÄISCHE PATENTANMELDUNG

(21) Anmeldenummer: **91103166.4**

(22) Anmeldetag: **02.03.91**

(51) Int. Cl.5: **H03F 3/60**

(30) Priorität: **31.03.90 DE 4010409**

(43) Veröffentlichungstag der Anmeldung:
**09.10.91 Patentblatt 91/41**

(84) Benannte Vertragsstaaten:
**DE FR GB IT NL**

(71) Anmelder: **Rohde & Schwarz GmbH & Co. KG**
**Mühldorfstrasse 15**
**W-8000 München 80(DE)**

(72) Erfinder: **Bauer, Helmut**
**Buchenweg 10**
**W-8134 Niederpöcking(DE)**
Erfinder: **Dalisda, Uwe, Dipl.-Ing.**
**Donaustrasse 29d**
**W-8037 Olching(DE)**

(74) Vertreter: **Graf, Walter, Dipl.-Ing.**
**Sckellstrasse 1**
**W-8000 München 80(DE)**

(54) **Hochfrequenz-Transistor-Leistungsverstärker.**

(57) Bei einem Hochfrequenz-Transistor-Leistungsverstärker mit mehreren kranzförmig angeordneten
Leistungstransistoren sind die Eingangs-Anschlüsse
der Transistoren über getrennte Eingangs-Anpaßschaltungen und eine Verteilerschaltung mit einem
gemeinsamen Eingang verbunden, während die
Ausgangs-Anschlüsse der Leistungstransistoren
ohne zwischengeschaltete Anpaßschaltungen unmittelbar in einem gemeinsamen Ausgangs-Anschluß
zusammengefaßt sind, der mit einer einzigen allen
Leistungstransistoren gemeinsamen AusgangsAnpaßschaltung verbunden ist.

EP 0 450 316 A2

Die Erfindung betrifft einen Hochfrequenz-Transistor-Leistungsverstärker mit mehreren kranzförmig angeordneten und elektrisch parallelgeschalteten Leistungstransistoren, wie er beispielsweise als Endstufe in Rundfunk- oder Fernseh-Sendern eingesetzt wird.

Hochfrequenz-Transistor-Leistungsverstärker dieser Art sind bekannt (US-PS 4 641 107, DE-OS 3 202 711). Bei diesen bekannten Leistungsverstärkern ist jedem einzelnen Leistungstransistor nicht nur eine gesonderte Eingangs-Anpaßschaltung, sondern auch eine gesonderte Ausgangs-Anpaßschaltung zugeordnet, es wird also für jeden einzelnen Transistor eingangsseitig und ausgangsseitig eine Widerstandstransformation und Entkopplung durchgeführt. Für große Leistungen von beispielsweise 1000 Watt oder mehr ist der Aufbau der Ausgangs-Anpaßschaltungen und der Koppeleinrichtungen zum Zusammenführen der einzelnen Transistor-Teilleistungen technisch relativ aufwendig, voluminös und teuer.

Es ist Aufgabe der Erfindung, einen Hochfrequenz-Transistor-Leistungsverstärker zu schaffen, der auch für große Leistungen relativ einfach und billig aufgebaut werden kann.

Diese Aufgabe wird ausgehend von einem Hochfrequenz-Transistor-Leistungsverstärker laut Oberbegriff des Hauptanspruches durch dessen kennzeichnende Merkmale gelöst. Vorteilhafte Weiterbildungen ergeben sich aus den Unteransprüchen.

Gemäß der Erfindung werden ausgangsseitig nicht mehr die bekannten Ausgangs-Anpaßschaltungen für jeden einzelnen Leistungstransistor vorgesehen, sondern die Ausgangs-Anschlüsse sämtlicher Leistungstransistoren werden unmittelbar möglichst induktionslos und transformationslos in einem gemeinsamen Ausgangsanschluß zusammengefaßt, d.h. die elektrische Verbindung der Ausgangsanschlüsse der Leistungstransistoren erfolgt derart, daß zwischen diesen Ausgangsanschlüssen und dem gemeinsamen Ausgangsanschluß keine widerstandstransformierenden oder induktionsbehaftete Leitungsabschnitte vorhanden sind. Eine besonders einfache Lösung hierfür ist, die einzelnen in einer Ebene liegenden Ausgangs-Anschlußfahnen der kranzförmig angeordneten Leistungstransistoren über eine axial aufgesetzte Metallscheibe galvanisch miteinander zu verbinden, eine solche Scheibe erfüllt diese Forderung nach induktionsloser und transformationsloser Verbindung der einzelnen Ausgangsanschlüsse am besten. Durch diese erfindungsgemäße Maßnahme werden teure und voluminöse Ausgangs-Anpaßschaltungen für die einzelnen Leistungstransistoren und die Koppeleinrichtung zur entkoppelten Zusammenführung der Teilleistungen überflüssig und es genügt eine einzige nachgeschaltete gemeinsame Ausgangs-Anpaßschaltung zur Widerstandstransformation auf den gewünschten Ausgangswiderstand des Leistungsverstärkers. Eingangsseitig werden in bekannter Weise weiterhin für jeden Leistungstransistor gesonderte Eingangs-Anpaßschaltungen benutzt, die über eine entsprechende Leistungsverteilerschaltung mit dem gemeinsamen Eingang verbunden sind. Durch entsprechende Ausgestaltung dieser Anpaßschaltungen und der Verteilerschaltung wird eine gute gegenseitige Entkopplung der einzelnen Leistungstransistoren erreicht, so daß trotz der direkten Verbindung der ausgangsseitigen Transistor-Anschlüsse ein Schwingen des Verstärkers durch Rückkopplung vermieden wird. Da eingangsseitig nur geringe Leistungen zu verarbeiten sind, können diese gesonderten Eingangs-Anpaßschaltungen und Verteilerschaltungen relativ einfach und preiswert beispielsweise in gedruckter Schaltungstechnik realisiert werden. Vorzugsweise werden Leistungstransistoren ausgewählt, die jeweils annähernd gleiche Verstärkung und gleichen Phasengang besitzen. Soweit dies nicht durch Auswahl entsprechender Transistortypen erreichbar ist, kann diese Forderung beispielsweise dadurch erfüllt werden, daß mindestens einigen der Transistoren eingangsseitig ein einstellbares Korrekturglied zugeordnet wird.

Ein erfindungsgemäßer Leistungsverstärker ist im Prinzip für alle Frequenzbereiche geeignet. Im Kurzwellenbereich kann die gemeinsame Ausgangs-Anpaßschaltung beispielsweise in konzentrierter Schaltungstechnik aufgebaut werden, im UKW-Bereich wird hierfür vorzugsweise eine Koaxialleitungstechnik benutzt, für Fernsehsender im Frequenzbereich über 400 MHz wird die gemeinsame Ausgangs-Anpaßschaltung beispielsweise als Topfkreis oder als Hohlraumresonator ausgebildet.

Neben diesen elektrischen Vorteilen eines erfindungsgemäßen Leistungsverstärkers ergibt sich auch eine besonders einfache und wirkungsvolle Art der Kühlung. Wenn die Transistoren beispielsweise auf der Innenwand eines Kühlrings befestigt sind können außen an diesem Ring entsprechende Kühlrippen ausgebildet werden und die Verlustwärme der Transistoren kann damit über diese Kühlrippen abgeführt werden. Es ist auch möglich, die Transistoren auf der Außenwand eines solchen Kühlringes zu befestigen und die Kühlrippen dann auf der Innenseite des Ringes auszubilden. Besonders vorteilhaft ist es, die gemeinsame Ausgangs-Anpaßschaltung in an sich bekannter Weise in Koaxialleitungstechnik auszubilden, was für die hier zu verarbeitenden hohen Leistungen einen besonders einfachen stabilen Aufbau ergibt. Wenn die Transistoren auf der Innenwand eines Kühlringes befestigt sind werden die koaxialen Elemente der Ausgangs-Anpaßschaltung einfach innerhalb des Kühlringes, der dann als Außenleiter wirkt, eingebaut. Wenn die Transistoren auf der Außenwand eines Kühlrings angebracht sind könnte der Kühlring als Innenleiter für die Koaxialleitungstechnik benutzt werden, der Kühlring muß dann nur noch von einem Außenleiterring umgeben werden. Die erfindungsgemäße ringförmige Anordnung der Transistoren ermöglicht also gleichzeitig auch noch eine sehr einfache und wirksame Kühlung und auch einen besonders einfachen Aufbau für die gemeinsame Ausgangs-Anpaßschaltung.

Die erfindungsgemäße Maßnahme ist für alle Arten von Leistungstransistoren geeignet, sowohl für Feldeffekttransistoren als auch für bipolare Transistoren und unabhängig davon ob die Verstärker als Linearverstärker (z.B. A-Betrieb oder als CW-Verstärker (z.B. C-Betrieb) arbeiten.

Die Erfindung wird im folgenden anhand schematischer Zeichnungen an einem Ausführungsbeispiel näher erläutert.

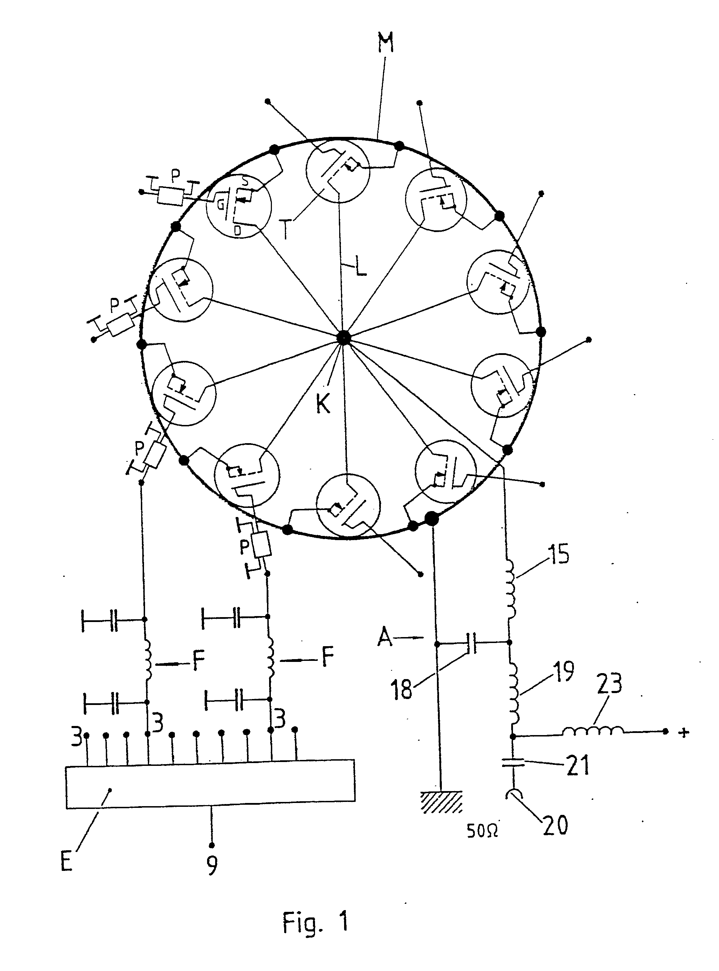

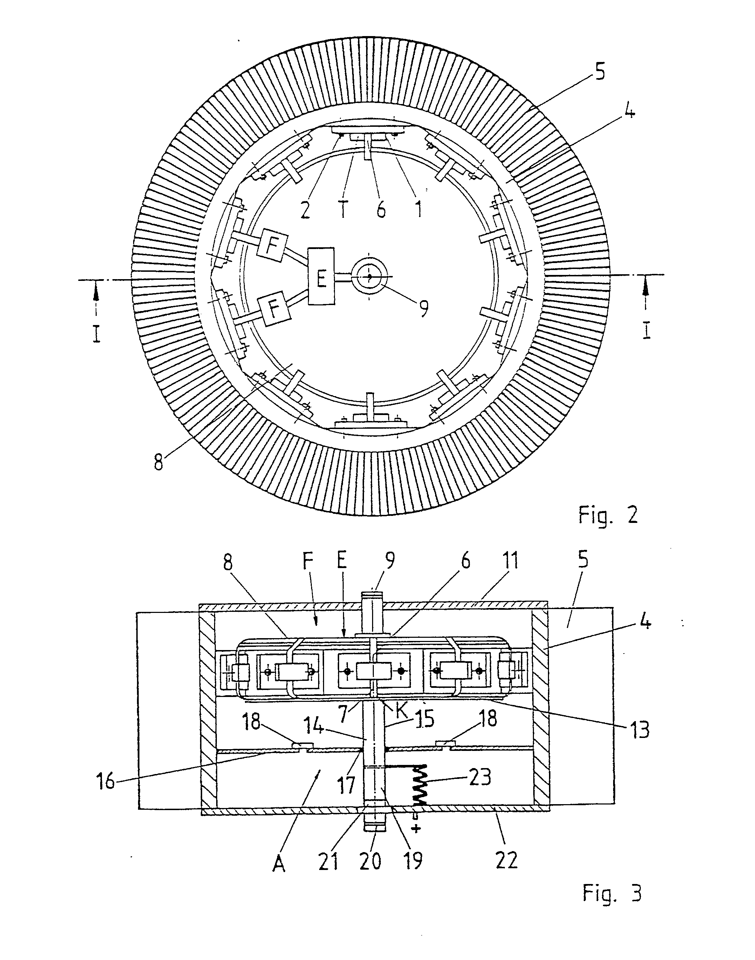

Fig. 1 zeigt das Prinzipschaltbild eines erfindungsgemäßen Hochfrequenz-Leistungsverstärkers, beispielsweise einer UKW-Sender-Endstufe, die aus zehn einzelnen Feldeffekt-Leistungstransistoren T mit einer Gesamtausgangsleistung von 1,5 kW aufgebaut ist. Die einzelnen Transistoren T sind kranzförmig angeordnet. In dem gezeigten Ausführungsbeispiel ist jeder Feldeffekt-Transistor T in Source-Schaltung betrieben, die Ausgangsanschlüsse sind also die Drain-Anschlüsse D. Diese Ausgangs-Anschlüsse D der einzelnen Transistoren T sind in einem gemeinsamen Ausgangs-Anschluß K zusammengefaßt, wie dies in Fig. 1 schematisch durch die Verbindungen L dargestellt ist. Diese Verbindungen L sind in der Praxis möglichst kurz ausgebildet, sie besitzen vor allem keinerlei widerstandstransformierenden Eigenschaften und sie sind auch möglichst induktionslos ausgebildet. In der Praxis hat sich hierfür die Verwendung einer Metallscheibe als besonders vorteilhaft erwiesen, durch welche die einzelnen Drain-Anschlüsse D der Transistoren T galvanisch miteinander verbunden sind, wie dies mit der Scheibe 13 im Ausführungsbeispiel nach Fig. 3 näher beschrieben ist. An diesem Ausgangs-Anschluß K ist eine für alle zehn Transistoren T gemeinsame Ausgangs-Anpaßschaltung A angeschaltet. Die Ausgangs-Anpaßschaltung A ist so dimensioniert, daß eine Widerstandstransformatin des gewünschten Ausgangswiderstandes von beispielsweise 50 Ω auf einen Widerstandswert von 1 Ω am Anschluß K erreicht wird. Nachdem jeder einzelne Transistor T einen Ausgangswiderstand von beispielsweise 10 Ω besitzt und in dem gezeigten Ausführungsbeispiel zehn Transistoren parallel-geschaltet sind, ergibt sich ein gemeinsamer Ausgangswiderstand am Anschluß K von 1 Ω, durch diese Dimensionierung der Anpaßschaltung A wird also für jeden einzelnen Transistor T der richtige Ausgangswiderstand von 10 Ω angeboten.

Die Source-Anschlüsse S der einzelnen Transistoren T sind mit einer gemeinsamen ringförmigen Masseleitung M verbunden.

Die Eingangsanschlüsse G (Gate-Anschlüsse) der einzelnen Transistoren sind jeweils über gesonderte Eingangs-Anpaßschaltungen F und einen Leistungsverteiler E in einem gemeinsamen Eingang 9 zusammengefaßt, als Leistungsverteiler E wird beispielsweise ein sogenannter Wilkinson-Verteiler benutzt, der die am Eingang 9 zugeführte Leistung auf zehn Ausgänge 3 verteilt, an denen die Eingangs-Anpaßschaltungen F angeschlossen sind, von denen in Fig. 1 der Übersichtlichkeit halber nur zwei dargestellt sind. Durch die jedem einzelnen Transistor T zugeordnete Eingangs-Anpaßschaltung F sowie den Leistungsverteiler E werden die Eingänge der einzelnen Transistoren T voneinander entkoppelt und so ein Schwingen durch Rückkopplung verhindert. Jede Eingangs-Anpaßschaltung F weist ferner noch ein Korrekturglied P auf, das beispielsweise in Form eines π-Gliedes ausgebildet ist. Jedes Korrekturglied P besitzt vorzugsweise einstellbare Bauelemente zum Einstellen der Verstärkung jedes einzelnen Transistors T, beispielsweise in Form von einstellbaren Dämpfungsgliedern, und außerdem einstellbare Blindwiderstandselemente zum Einstellen jeweils gleicher Phase an den Ausgängen D der Transistoren T. Mittels dieser Korrekturglieder P ist es möglich, jeden Transistor T auf gleiche Verstärkung und gleichen Phasengang wie die anderen Transistoren abzugleichen, bzw. diese Korrekturglieder P von Anfang an so zu dimensionieren, daß alle Transistoren gleiche Verstärkung und gleichen Phasengang besitzen. Die Eingangs-Anpaßschaltungen F sind in bekannter Weise so dimensioniert, daß wieder eine Widerstandsanpassung zwischen Eingangswiderstand des Transistors T und dem Ausgang der Entkopplungsschaltung E erzielt wird.

In dem gezeigten Ausführungsbeispiel sind zehn einzelne Transistoren parallelgeschaltet, die Anzahl der Transistoren richtet sich nach der gewünschten Ausgangsleistung des Verstärkers, es können beliebig viele Transistoren, beispielsweise zwanzig, dreißig oder mehr parallelgeschaltet werden.

Ein praktisches Ausführungsbeispiel eines erfindungsgemäßen Leistungsverstärkers für UKW mit wiederum zehn ringfömig angeordneten Transistoren zeigen Figuren 2 und 3. Fig. 2 zeigt die Draufsicht mit abgenommenem oberen Deckel und Fig. 3 zeigt den zugehörigen Schnitt längs der Linie I-I nach Fig. 2. Die einzelnen Transistoren T sind hierbei über ihre Flansche 1 beispielsweise mittels Schrauben 2 auf der Innenwand eines Kühlringes 4 befestigt, an dem radial nach außen abstehende Kühlrippen 5 ausgebildet sind. Die Ein- und Ausgangsanschlüsse G und D der einzelnen Transistoren sind als nach oben und unten axial abstehende und nach innen radial abgebogene Federkontaktstreifen 6 und 7 ausgebildet, die in einer Ebene liegen. Die Flansche 1 der einzelnen Transistoren sind unmittelbar mit dem Kühlring 4 galvanisch verbunden. Die Verbindung der Platte 1 mit der Innenwand des Kühlringes 4 ist gut wärmeleitend, so daß die Verlustwärme der einzelnen Transistoren über den Kühlring 4 gut abgeleitet wird. Die Halbleiterplättchen der einzelnen Transistoren T können auch unmittelbar in kranzförmiger Anordnung auf der Innen- oder Außenwand des Kühlringes ausgebildet sein, dadurch wird ein noch besserer Wärmeübergang und eine weitere Vereinfachung des Gesamtaufbaus erreicht.

Die einzelnen Eingangs-Anpaßschaltungen F mit den zugehörigen Korrekturgliedern P und dem Verteiler E sind beispielsweise auf einer Leiterplatte 8 in gedruckter Schaltungstechnik aufgebaut, die Eingangs-Anschlußfahnen 6 der Transistoren sind unmittelbar mit den entsprechenden Anschlußpunkten dieser gedruckten Schaltung auf der Leiterplatte 8 verbunden. Der Eingang 9 des Verteilers E wird durch eine Anschlußbuchse gebildet, die durch den in Fig. 2 abgenommenen Abschlußdeckel 11 nach außen ragt.

Die Ausgangs-Anschlußfahnen 7 (Drain-Anschlüsse D) der Transistoren T sind über eine von der Unterseite her aufgesetzte Metallscheibe 13, die mit ihrem Rand auf den Anschlußfahnen 7 aufliegt, galvanisch miteinander verbunden, die Mitte K dieser Metallscheibe 13 bildet den gemeinsamen Ausgangs-Anschluß für die direkt zusammengefaßten Ausgangs-Anschlüsse D der Transistoren. Die Größe und Dicke dieser Metallscheibe 13 ist so gewählt, daß für den jeweiligen Betriebsfrequenzbereich diese Verbindung zwischen Anschlußfahnen 7 und gemeinsamen Ausgangs-Anschluß K möglichst induktionslos und auch transformationslos erfolgt. In der Mitte K dieser Metallscheibe 13 ist ein Innenleiterstück 14 aufgesetzt und mit der Scheibe 13 galvanisch verbunden. Dieses Innenleiterstück 14 bildet zusammen mit dem Kühlring 4 als Außenleiter ein Koaxialleitungssystem, durch den ersten Innenleiterabschnitt 15 zwischen der Kontaktscheibe 13 und einer Zwischenscheibe 16, die über einen Kontaktfederring 17 mit dem Innenleiter 14 galvanisch verbunden ist, wird die erste Induktivität 15 der Ausgangs-Anpaßschaltung A gebildet, auf der Zwischenscheibe 16 sind symmetrisch rings um den Innenleiter 14 Kondensatoren 18 ausgebildet, deren anderer Anschluß unmittelbar am Rand der Zwischenscheibe 16 mit der Innenwand des Kühlringes 4 galvanisch verbunden ist. Der anschließende Innenleiterabschnitt 19 bildet die zweite Induktivität 19 der Anpaßschaltung A, zwischen dem stirnseitigen Ende des Innenleiters 14 und dem Innenleiter der Ausgangsbuchse 20 ist zur Bildung des Koppelkondensators 21 eine Isoliermaterialscheibe 21 zwischengelegt. Die Speisespannungszufuhr für die Transistoren erfolgt isoliert durch den Abschlußdeckel 22 über eine Drosselspule 23, die mit dem Innenleiterstück 19 verbunden ist.

**Patentansprüche**

1. Hochfrequenz-Transistor-Leistungsverstärker mit mehreren kranzförmig angeordneten Leistungstransistoren (T), deren Eingangs-Anschlüsse (G) über getrennte Eingangs-Anpaßschaltungen (F) und eine Verteilerschaltung (E) mit einem gemeinsamen Eingang (9) verbunden sind, dadurch **gekennzeichnet**, daß die Ausgangs-Anschlüsse (D) der Leistungstransistoren (T) ohne zwischengeschaltete Anpaßschaltungen unmittelbar in einem gemeinsamen Ausgangs-Anschluß (K) zusammengefaßt sind, der mit einer einzigen allen Leistungstransistoren (T) gemeinsamen Ausgangs-Anpaßschaltung (A) verbunden ist.

2. Leistungsverstärker nach Anspruch 1, dadurch **gekennzeichnet**, daß die Leistungstransistoren (T) so angeordnet sind, daß ihre Ausgangs-Anschlüsse (D,7) kranzförmig in einer Ebene liegen und über eine ebene Kontaktscheibe (13) galvanisch miteinander verbunden sind, wobei die gemeinsame Ausgangs-Anpaßschaltung (A) in der Mitte (K) dieser Kontaktscheibe (13) angeschlossen ist.

3. Leistungsverstärker nach Anspruch 1 oder 2, dadurch **gekennzeichnet**, daß die gemeinsame Ausgangs-Anpaßschaltung (A) als Koaxialleitungs-, Topfkreis- oder Hohlleiter-System ausgebildet ist.

4. Leistungsverstärker nach Anspruch 2 oder 3, dadurch **gekennzeichnet**, daß in der Mitte (K) der Kontaktscheibe (13) ein konzentrisch zum Kranz der Leistungstransistoren (T) angeordnetes Innenleiterstück (14) galvanisch befestigt ist und die gemeinsame Ausgangs-Anpaßschaltung (A) innerhalb des Transistorkranzes in Koaxialleitungstechnik ausgebildet ist (Koaxialleitungssystem 4, 14 bis 21).

5. Leistungsverstärker nach einem der vorhergehenden Ansprüche, dadurch **gekennzeichnet**, daß die Leistungstransistoren (T) in kranzförmiger Anordnung mit ihrem Flansch (1) auf der Innenseite eines Kühlringes (4) befestigt sind.

Fig. 1

Fig. 2

Fig. 3